(19) Europäisches Patentamt
European Patent Office
Office européen des brevets

(11) EP 2 660 976 A1

(12) EUROPEAN PATENT APPLICATION

(43) Date of publication:
06.11.2013 Bulletin 2013/45

(51) Int Cl.:
$H03G\ 3/30\ ^{(2006.01)}$

(21) Application number: 12174581.4

(22) Date of filing: 02.07.2012

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME

(30) Priority: 30.04.2012 EP 12368013

(71) Applicant: ST-Ericsson SA
1228 Plan-les-Ouates (CH)

(72) Inventors:
• Rosendahl, Jens
  FI-20100 TURKU (FI)
• Lindström, Riku
  FI-21500 KAARINA (FI)

(74) Representative: Ström & Gulliksson AB
P.O. Box 793
220 07 Lund (SE)

(54) **Minimizing unwanted spectral emission of a wireless communication transmitter**

(57)     A system of a wireless communication transmitter is disclosed. The system is adapted to minimize switching transient spectral emission of the transmitter due to a power ramp. The power ramp comprises a base level and a ramp shape. The system comprises a power amplifier and a base level generator, wherein the base level generator is adapted to compensate the base level based on changes in variables of the power amplifier.

The system may also comprise a ramp shape generator adapted to generate the ramp shape, and a combiner adapted to combine the base level and the ramp shape to provide a power amplifier control signal. A power amplifier controller may be adapted to control a power amplifier supply voltage based on the power amplifier control signal.

Corresponding method, computer program product, wireless communication transmitter and device are also disclosed.

Fig. 3

## Description

## Technical Field

The invention relates to the field of electronic circuits and more particularly to the field of power amplifiers of TDMA transmitters.

## Background

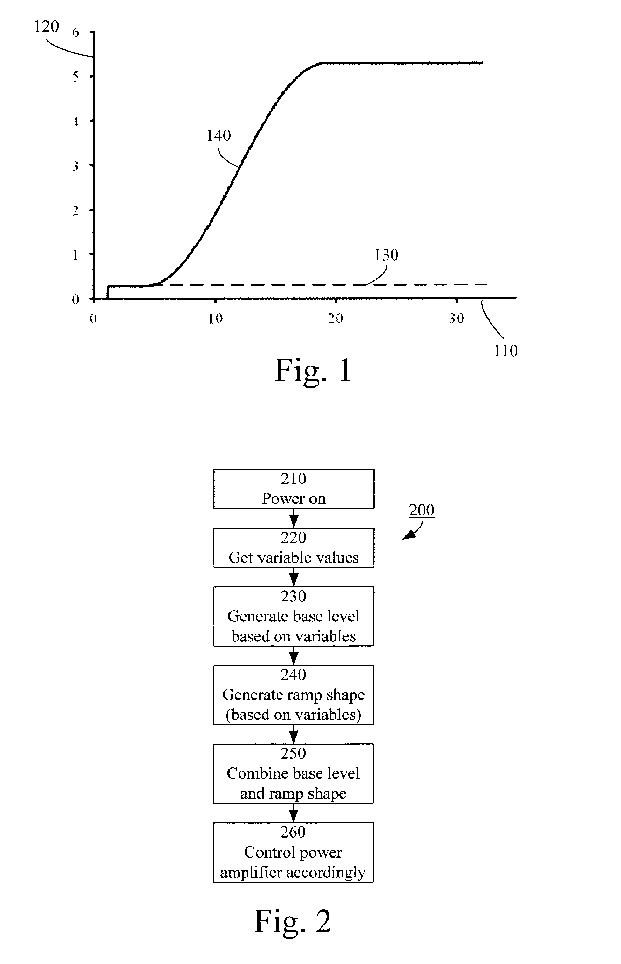

In time division multiple access (TDMA) technologies, data is transmitted in bursts. In order for a transmitter to utilize its time slots efficiently it needs to ramp up and down its power as fast as possible. At the same time spectral radiation originating from the ramps, SdT (Spectrum due to switching Transients), should be minimized to not cause interference on other frequencies. The minimum possible spectral radiation during a power ramp is equal to the spectral radiation during the burst, SdM (Spectrum due to Modulation). A reasonable fast ramp with a minimum of unwanted radiation is achievable by shaping the supply voltage to the radio frequency (RF) power amplifier (PA) as a raised cosine (RC) curve pre-pended by a short period of direct current (DC) (see Figure 1). The DC is named base level (BL) and it will help the power amplifier to overcome the operational difficulties related with very low supply voltages (e.g. gain curve notch), which can have an impact on SdT performance.

In practice the base level is usually of a fixed value or it can be calibrated in production e.g. as a function of the transmitters lowest possible power level (to overcome unit-to-unit variations in the PA).

A transmitter with such a fixed or calibrated base level value may, as the operating conditions change, experience non-optimal levels of the unwanted spectral emission due to the power ramp (SdT). It would be desirable to minimize the unwanted spectral emission regardless of the current operating conditions.

KR20070073069A discloses an output spectrum property improvement system due to a switching transient. Ramp profiles are applied for each PCL (Power Control Level) of an area corresponding to a traffic channel set during burst transmission, thereby improving output spectrum property due to a switching transient. An area definer defines a low channel area, a middle channel area, and a high channel area for each frequency band. A profile storage stores ramp profiles for each PCL in the defined low, middle, and high channel areas. An applier decides to which area a set traffic channel corresponds, and reads a ramp profile corresponding to the set PCL of the corresponding area to apply the read profile to a power amplifier.

A transmitter using such an approach may still experience non-optimal levels of the unwanted spectral emission.

Therefore, there is a need for methods, systems and devices that minimize unwanted switching transient spectral emission of a wireless communication transmitter due to a power ramp.

## Summary

It should be emphasized that the term "comprises/comprising" when used in this specification is taken to specify the presence of stated features, integers, steps, or components, but does not preclude the presence or addition of one or more other features, integers, steps, components, or groups thereof.

It is an object of some embodiments to obviate at least some of the above disadvantages and to provide methods, systems and devices that minimize unwanted switching transient spectral emission of a wireless communication transmitter due to a power ramp.

It is an object of some embodiments to compensate the base level for changes in variables, such as transmitter power level, temperature and the like, in order to keep the SdT of the transmitter in an optimal point. Two methods have been identified: compensation by modeling the optimal base level and automatic compensation by measuring the actual spectral emissions. It should be noted that a system could also be based on a mixture of both of the above mentioned methods.

A first aspect is a method of minimizing switching transient spectral emission of a wireless communication transmitter due to a power ramp, wherein the power ramp comprises a base level and a ramp shape. The method comprises compensating the base level based on changes in variables of a power amplifier of the transmitter.

The wireless communication transmitter may comprise a power amplifier and the power ramp may be used to control the power amplifier. The transmitter may be a TDMA transmitter, but embodiments may also be applicable to all transmitters experiencing unwanted switching transient spectral emissions due to power ramp up (or power ramp down).

The base level is a DC level that is combined with the power ramp shape (aka power ramp profile) to produce the power ramp. The base level is typically applied at least in an interval before the power ramp shape becomes non-zero, which improves the power amplifier operation at very low supply voltages. Thus, the base level may be seen as a floor in terms of power amplifier voltage that the ramp shape starts from. An equivalent notation for base level is pedestal.

The compensation of the base level according to the method may comprise dynamically adjusting the base level based on variables such as operating condition parameters and/or operating point parameters.

In some embodiments, the compensation may be based on at least one current (or momentary) parameter value. The variables of the power amplifier may comprise one or more of a transmitter power level, a power amplifier voltage, a power amplifier input power level, a power level index, a power control level, a current frequency band, a fuse value, a tuning value, a timing value, a ramp shape, a temperature (e.g. of the transmitter or of the power amplifier), and a power amplifier age. A tuning value may, for example, comprise a calibration parameter value (e.g. stored in a non-volatile memory) and might be used for tuning in device production. A fuse value may, for example, comprise a calibration parameter value and might be used for tuning in chip production. A timing value may comprise a timing of power amplifier input power signal and/or a duration of the base level signal.

Compensating the base level may be performed by modeling an optimal base level according to some embodiments. In such embodiments, the compensation may be based on a model of power amplifier behavior (e.g. of unwanted switching transient spectral emission).

The model may comprise variations of the switching transient spectral emission as a function of the variables of the power amplifier and the base level value, and the compensation may comprise selecting the optimal base level value for each variable operating point as the base level that gives the lowest switching transient spectral emission.

The model may alternatively comprise the optimal base level value as a function of the variables of the power amplifier.

The function may be calculated during operation, or it may be pre-calculated and tabulated (e.g. in a look-up table (LUT)).

In some embodiments, compensating the base level may be performed by (automatic) compensation based on a power amplifier output measurement. In such embodiments, the method may further comprise measuring the actual spectral emission (e.g. the actual unwanted spectral emission) at the power amplifier output and the compensation may comprise adapting the base level based on the measurements.

Compensating the base level may performed by modeling an optimal base level based on a power amplifier output measurement according to some embodiments. Thus, compensating the base level may performed by providing the power amplifier output measurement as an input to the optimal base level modeling.

In some embodiments, the method may further comprise adjusting the ramp shape based on the changes in variables of the power amplifier.

The adjustment of the ramp shape may be based on similar considerations as the compensation of the base level. Thus, the adjustment of the base level may be performed by modeling an optimal ramp shape and/or by (automatic) compensation based on a power amplifier output measurement according to some embodiments. The adjustment of the ramp shape may be based on one or more of a transmitter power level, a power amplifier voltage, a power level index, a power control level, a temperature, and a power amplifier age.

A second aspect comprises a system of a wireless communication transmitter. The system is adapted to minimize switching transient spectral emission of the transmitter due to a power ramp wherein the power ramp comprises a base level and a ramp shape. The system comprises a power amplifier, and a base level generator adapted to compensate the base level based on changes in variables of the power amplifier.

The system according to the second aspect may be implemented using discrete components, a plurality of modules or a single module (e.g. chip).

The compensated base level may be used to generate a power amplifier control signal. The power amplifier control signal may be used to control the power amplifier. In some embodiments, the power amplifier control signal may be directly input to the power amplifier. In other embodiments, the system may further comprise a power amplifier controller adapted to control a power amplifier supply voltage (a.k.a. collector voltage) based on the power amplifier control signal.

In some embodiments, the system further comprises a measurement unit (e.g. measurement receiver or a radio tester) adapted to provide a power amplifier output measurement as an input to an optimal base level modeling. The measurement unit may be integral to the base level generator according to some embodiments.

The system may, in some embodiments, further comprise a ramp shape generator adapted to generate the ramp shape, and a combiner (e.g. an adder) adapted to combine the base level and the ramp shape to provide the power amplifier control signal. For example, the ramp shape generator may be adapted to adjust the ramp shape based on the changes in variables of the power amplifier.

A third aspect is a wireless communication transmitter comprising the system of the second aspect.

A fourth aspect is a wireless communication device (e.g. a user equipment) comprising the system of the second aspect or the transmitter of the third aspect.

A fifth aspect is a computer program product comprising a computer readable medium, having thereon a computer program comprising program instructions, the computer program being loadable into a data-processing unit and adapted to cause the data-processing unit to execute the method according to the first aspect when the computer program is run by the data-processing unit.

In some embodiments, the second, third, fourth and fifth aspects may additionally have features identical with or corresponding to any of the various features as explained above for the first aspect.

Some embodiments provide a method for compensating the base level for changes in variables of a power amplifier such as transmitter power levels and/or temperature. The method may be **characterized in that** it uses compensation by modeling the optimal base level.

Some embodiments provide a method for compensating the base level for changes in variables of a power amplifier such as transmitter power levels and/or temperature. The method may be **characterized in that** it uses automatic compensation by measuring the actual spectral emissions.

Some embodiments provide a method for compensating the base level for changes in variables of a power amplifier that uses a combination of compensation by modeling the optimal base level and automatic compensation by measuring the actual spectral emissions.

Some embodiments provide a power amplifier for a wireless communication system having means for compensating the base level for changes in variables of said power amplifier such as transmitter power levels and/or temperature. Said compensation may be based on the modeling the optimal base level.

Some embodiments provide a power amplifier for a wireless communication system having means for compensating the base level for changes in variables of said power amplifier such as transmitter power levels and/or temperature. It may use means for performing automatic compensation based on the measurements of the actual spectral emissions.

Some embodiments provide a power amplifier for a wireless communication system that includes means for performing a combination of compensation by modeling the optimal base level and automatic compensation by measuring the actual spectral emissions.

The power amplifier may be a power amplifier for a TDMA transmitter according to some embodiments.

Some embodiments provide a user equipment that includes a power amplifier according to any of the aspects above.

An advantage of some embodiments is that unwanted switching transient spectral emission of a wireless communication transmitter due to a power ramp may be minimized.

The unwanted switching transient spectral emissions may be kept at an optimum or close to optimum level. According to some embodiments, the unwanted switching transient spectral emissions may be kept at a level close to the transmission modulation spectrum.

Another advantage of some embodiments is that the unwanted switching transient spectral emissions may be kept low also under non-nominal operating conditions.

Yet an advantage of some embodiments is that phenomena such as unit to unit variations and aging of the power amplifier may be compensated for by adapting based on power amplifier output measurements.

A further advantage of some embodiments is that a low complexity implementation is possible. This is particularly true with regard to the embodiments where only the base level value is compensated.

Another advantage of some embodiments is that a possibility is provided to use less complex/costly power amplifiers by compensating for non-optimal PA characteristics.

**Brief Description of the Drawings**

Further objects, features and advantages will appear from the following detailed description of embodiments, with reference being made to the accompanying drawings, in which:

Fig. 1 is a schematic plot illustrating a typical PA-voltage ramp with a base level;
Fig. 2 is a flowchart illustrating example method steps according to some embodiments;
Fig. 3 is a block diagram illustrating an example arrangement according to some embodiments;
Fig. 4 is a schematic plot illustrating an example of base level modes according to some embodiments;
Fig. 5 is a block diagram illustrating an example arrangement applying base level compensation based on modeling according to some embodiments; and
Fig. 6 is a block diagram illustrating an example arrangement applying base level compensation based on measurements and adaptation according to some embodiments.

**Detailed Description**

In the following, various embodiments of power amplifier (PA) base level compensation in TDMA transmitters will be described. It should be noted that embodiments of the invention are applicable to any PA ramping situation where it is desired to minimize some part of the emission (e.g. some spectral components). For example, embodiments may be applicable to any TDMA or TDD system, e.g. GSM and TD-SCDMA. Some embodiments may be particularly useful in applications where transmission is done in bursts, where there are tight adjacent channel interference (ACI) requirements, and/or where a system is very sensitive to unwanted emissions in any other way.

In typical known systems, the base level and its calibration are designed in order to be optimal for the maximum burst power level in nominal temperature. This means that when the transmitter is operating on lower power levels and in non-nominal temperatures the SdT may not be optimal, although possibly lower. In extreme conditions certain commercially available PA types might even fail specification limits.

Embodiments will be described herein where unwanted spectral emission of a wireless communication transmitter due to a power ramp is minimized.

Unwanted spectral emission may for example comprise emitted power or energy located in a frequency region outside or close to the edge of the transmission channel. The unwanted spectral emission may be minimized, for example, by minimizing the total off-band emitted energy or by minimizing a maximum value of emitted energy among the off-band frequencies. Minimizing may comprise finding an overall minimum, a local minimum, or a value close to an overall or local minimum (e.g. when applying quantization of some or all of the involved parameters). In the general case, minimizing may comprise finding an operating point (e.g. a base level value) that provides a lower unwanted spectral emission than an approach that does not apply any embodiments as described herein.

The power ramp comprises a base level and a ramp shape as illustrated in Figure 1. The example power ramp is shown in form of a corresponding voltage ramp 140, whereof the base level 130 is one component. The x-axis 110 shows time in micro seconds and the y-axis 120 shows power amplifier voltage in Volts. In this example the ramp 140 comprises the base level 130 plus a raised cosine (RC) ramp shape.

Other ramp shapes than the one showed in Figure 1 may alternatively be applied. For example, the roll-off (and/or roll-on) factor of the RC shape may be varied. A squared RC shape may be used in some scenarios. Some embodiments may apply pre-distortion (or pre-emphasis) of an initial ramp shape (e.g. an RC shape) to appropriately alter the initial ramp shape.

It may be noted that, although the PA voltage is ramped with a certain shape, the shape is not necessarily the same in the RF output power from the PA. The shape of the RF output power from the PA may typically depend on the PA voltage shape, the PA input power level and the PA characteristics. Thus, to achieve a wanted RF output curve shape (e.g. an RC shape), it may be beneficial to input a different PA voltage curve shape. For example, in some situations a RC curve shape altered by pre-distortion/pre-emphasis as PA voltage may result in a RC curve shape at the RF output of the PA.

The ramp shape to be used may, for example, be read from a LUT or calculated during operation.

In some embodiments, the minimization is achieved by compensating the base level based on changes in variables of a power amplifier of the transmitter.

Figure 2 illustrates an example method 200 according to some embodiments. The method starts in 210 when a transmitter comprising a power amplifier is to be turned on for transmission.

Adequate variable values of the power amplifier are acquired in 220. In some embodiments, the variables of the power amplifier may comprise at least one current (or momentary) parameter value, such as one or more of a transmitter power level, a power amplifier voltage, a power level index, a power control level, a temperature (e.g. of the transmitter or of the power amplifier), a power amplifier age and a power amplifier output measurement (e.g. the actual unwanted spectral emission at the power amplifier output). In some embodiments, operating condition parameters and/or operating point parameters may be used. The values of the variables may be obtained from a sensor (e.g. for the temperature), a measurement unit, a transmitter input signal (e.g. the power amplifier voltage), a register (e.g. age), or any other suitable sources.

In 230, a base level is generated based on the variables of the power amplifier. As the values of the variables may change, the generation may be dynamic. In some embodiments a default base level is set (e.g. in accordance with prior art methods) and is compensated based on the variables of the power amplifier.

Compensating the base level in 230 may be performed by modeling an optimal base level. That is, the compensation may be based on a model of power amplifier behavior (e.g. unwanted spectral emission) for various base level values.

Any suitable representation may be used for the model, such as a LUT (with or without interpolation/extrapolation) or a formula. For example, the model may be represented as a sum of functions:

$$F(\bar{x}) = \sum_{k=1}^{n} f_k(x_k),$$

where each function $f_k(x_k)$ describes the model's dependence to one particular parameter $x_k$. A function could e.g. take the general form:

$$f_k(x_k) = A_k + B_k x_k + C_k x_k{}^2 + \ldots + D_k x_k{}^m.$$

It should be noted that any suitable mathematical expression could be used, as well as more programmatic constructs like if/else sentences.

An illustrative example may be presented as follows, where $x_1$ represents the PA temperature (normalized around 25°C, i.e. $x_1 = 0$ corresponds to 25°C) and $x_2$ represents a power level index (e.g. PCL, normalized so that 0 equals the maximum power level):

$$f_1(x_1) = A_1 + B_1 x_1 + C_1 x_1{}^2, \qquad A_1 = 10, \qquad B_1 = 1, \qquad C = -0.01$$

$$f_2(x_2) = A_2 + B_2 x_2, \qquad A_2 = 100, \qquad B_2 = -5$$

Thus, if $x_1 = 20$ (i.e. 45°C) and $x_2 = 4$, we get a value relating to the base level of:

$$F(\bar{x}) = 10 + 1 * 20 - 0.01 * 400 + 100 - 4 * 5 = 106.$$

Depending on how the model is used, this value may, for example, either be directly used in a controller (e.g. a DA converter) setting the base level or be used as a compensation value that is added or subtracted from some default base level value.

Compensating the base level in 230 may be alternatively or additionally performed by compensation based on a power amplifier output measurement. In such embodiments, step 220 may comprise performing measurements of the power amplifier output and the compensation may comprise adapting the base level based on the measurement result.

For example, measurements of SdT at the power amplifier output may be performed by a radio tester equipment (in accordance with the GSM standard, a radio tester may measure the entire burst emissions). The output signal may be measured in the time domain and/or in the frequency domain. In GSM, a +/-400 kHz offset compared to the carrier frequency typically represent the most problematic unwanted signal regions. In other examples, (at least part of) the radio tester functionality may be implemented as an on-chip measurement receiver together with appropriate logic and/or software to control it.

The measurements may comprise any relevant and suitable entities, e.g. total adjacent channel emission (in time or frequency domain) and/or components (in time or frequency domain) related to ramps only (e.g. measuring only in time windows during ramp-up and ramp-down).

In some embodiments, compensating the base level in 230 may be performed by a combination of the two methods, e.g. modeling an optimal base level based on a power amplifier output measurement result. In such embodiments, the power amplifier output measurement result is typically provided as an input to the optimal base level modeling.

A ramp shape is generated in 240 and combined (e.g. by addition) with the base level in 250. The result is used to control the power amplifier in 260 to minimize unwanted emissions due to the power ramp-up. For example, in a typical GSM transmitter the ramp shape may be generated by a ramp generator, the base level may be added and the compound signal may be used to control the voltage of a DC/DC converter that feeds the final voltage to the PA.

It should be noted that similar consideration may be applicable at power-ramp down (turning off the power amplifier and/or transmitter). Thus, embodiments of the invention are equally applicable for power ramp-down.

In some embodiments, the generation of the ramp shape in 240 may comprise generating a pre-determined ramp shape. In other embodiments, the generation of the ramp shape in 240 may comprise adjusting the ramp shape based on the changes in variables of the power amplifier. The adjustment of the ramp shape may be based on similar considerations as the compensation of the base level.

Adjustment may comprise changing the ramp shape curve from a first mathematical function to a second function mathematical. Adjustment of the ramp shape may, for example, comprise varying the roll-off (and/or roll-on) factor of an RC shape or a squared RC shape. According to another example, the adjustment may alternatively or additionally comprise applying varying pre-distortion (or pre-emphasis) of an initial ramp shape to alter the initial ramp shape. According to yet another example, the adjustment may alternatively or additionally comprise varying the ramp time (i.e. the duration of the ramp).

As mentioned before, the ramp shape to be used may, for example, be read from a LUT or calculated during operation.

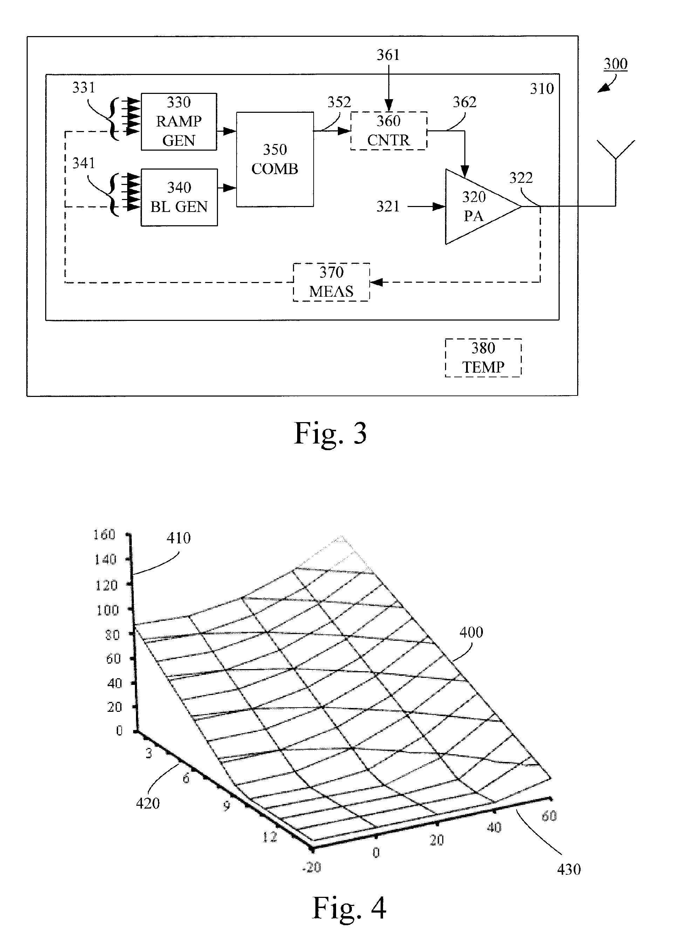

Figure 3 illustrates an example arrangement or system 310 for minimizing unwanted spectral emission due to a power ramp according to some embodiments. The arrangement may be comprised in a device 300, for example a transmitter and/or a wireless communication device. The arrangement may be implemented as a single module or as many individual modules. At least some parts of the arrangements may be implemented in software according to some embodiments.

The arrangement comprises a power amplifier (PA) 320 (having an RF input 321 and an RF output 322), a base level generator (BL GEN) 340, a ramp shape generator (RAMP GEN) 330 and a combiner (COMB) 350.

The base level generator generates a base level based on input signals 341 (for example as described in connection to 230 of Figure 2) and the ramp shape generator generates a ramp shape (for example as described in connection to 240 of Figure 2). If the ramp shape generator applies dynamic ramp shape generation, the generation may be based on input signals 331.

The combiner 350 combines the generated base level and ramp shape (for example by adding them) and outputs a power amplifier control signal 352 which is used to control the power amplifier 320.

In some embodiments, the power amplifier control signal 352 may be directly input to the power amplifier at 362. In other embodiments, the system may further comprise a power amplifier controller 360 that receives the power amplifier control signal 352 as an input signal and outputs a power amplifier supply voltage 362 to control the power amplifier based on the power amplifier control signal. The controller 360 may be fed by a supply voltage 361. In some embodiments, the controller may be implemented as a DC/DC converter.

The input signals 331 and 341 may, for example, comprise the power amplifier variable values as described above in connection to 220 of Figure 2. A temperature sensor 380 may provide a temperature input signal at 331 and/or 341.

In some embodiments, the base level generation and/or the ramp shape generation may be based on a power amplifier output measurement. In such embodiments, a measurement unit (MEAS) 370 may perform measurements on the power amplifier output 322 and provide measurement result values as an input at 331 and/or 341. Alternatively, the measurement unit may be comprised in the base level generator 340 and/or the ramp shape generator 330.

As mentioned earlier the base level generation may comprise applying an optimum base level model and/or compensating based on the power amplifier output. Figure 4 illustrates an example of a base level model according to some embodiments. The optimum base level (in mV) 410 is shown as a function 400 of temperature (in °C) 430 and power control level indications (given as PCL values) 420.

As seen in this example, base level compensation based on power level (PCL) may comprise a linear model (i.e. exponentially proportional to the PA voltage). Typically, base levels get reduced to zero at the lowest power levels. Compensation based on temperature may comprise one, two or more linear models (four in the example of Figure 4). Minimum and maximum values of the base level may also be defined.

An example implementation of a method to calibrate a model for GSM using a radio tester based on a linear dependency on PCL and two linear dependencies on temperature (one above 25°C and one below) comprises turning off the base level compensation and searching for a base level value which minimizes the SdT for a suitable initial PCL setting (e.g. a PCL corresponding to the maximum power). A time domain view of the burst power at an offset frequency (e.g. +/- 400 kHz) may be used to find (e.g. by sweeping base level values) an operation point with optimum (e.g. minimum) disturbance. In some scenarios, it may be needed to find a balance between ramp-up and ramp-down disturbances if one increases while the other decreases. The disturbances in the form of switching transients may, for example, be viewed as an elevated emission in a time domain view at the beginning and end of a burst. Ideally there should be no elevated emission at this PCL value.

The base level is then forced to zero and a PCL value is determined (e.g. by sweeping the PCL values) where the elevated emission start to appear. An initial slope is selected that crosses base level zero at the just determined PCL value and goes though the base level point found for the initial PCL (example: BL=100 at initial PCL=0 and BL=10 at PCL=15 gives a slope of-6).

Then the base level compensation may be turned on and a full PCL sweep on some different traffic channels (transmit frequencies) may be repeatedly performed while varying the slope value until an optimum model (slope) is found.

Defining the model for temperature variations may comprise placing the unit in a temperature chamber or otherwise controlling the temperature. The above procedure may be performed for 25°C. The method may continue by turning off the base level compensation and searching for an optimal base level value which minimizes the SdT for a suitable temperature setting (e.g. -10°C) and power control level setting (e.g. the initial PCL). A slope may be calculated based on the two determined base level values for the two temperatures (-10°C and 20°C), and the process may be repeated for another suitable temperature setting (e.g. 60 °C).

Then the base level compensation may be turned on and a full PCL sweep on different channels may be repeatedly performed while varying the slope values until an optimum model is found.

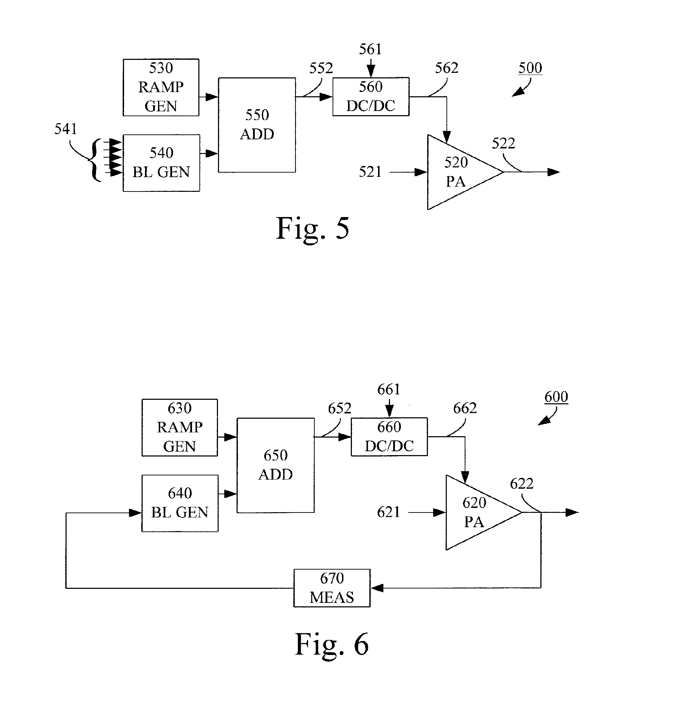

Turning now to Figures 5 and 6, two specific embodiments will be described, which may be seen as special cases to the embodiments described in connection to Figure 3, and principles described in connection thereto may be applicable also to the embodiments of Figure 5 and 6.

Figure 5 illustrates an example arrangement or system 500 for minimizing unwanted spectral emission due to a power ramp according to some embodiments.

In this example, the optimal base level to use is modeled based on a set of in signals. These in signals can be e.g. PA-Voltage (or power level index), temperature, calibration values, PA-type and the like. The model can be constructed by using any function, look up table or algorithm suitable for the purpose. A typical setup, based on modeling the Power Control Level (PCL) and temperature behavior, could look like the one in Figure 4.

The arrangement 500 comprises a power amplifier (PA) 520 (having an RF input 521 and an RF output 522), a base level generator (BL GEN) 540 (e.g. a base level model), a ramp shape generator (RAMP GEN) 530 and an adder (ADD) 550.

The base level generator generates a base level based on input signals 541 (for example as described in connection to 230 of Figure 2) and the ramp shape generator generates a ramp shape (for example as described in connection to 240 of Figure 2).

The adder 550 combines the generated base level and ramp shape and outputs a power amplifier control signal (PA voltage control) 552 which is used to control the power amplifier 520.

In this embodiment, the system comprise a DC/DC converter 560 that receives the power amplifier control signal 552 as an input signal and outputs a power amplifier supply voltage (PA voltage) 562 to control the power amplifier based on the power amplifier control signal. The DC/DC converter 560 is fed by a supply voltage 561.

Figure 6 illustrates an example arrangement or system 600 for minimizing unwanted spectral emission due to a power ramp according to some embodiments.

In this example, the optimal base level is determined based on adaptation. A receiver is used to measure the spectral energy during the ramps and an adaptive algorithm is used to adjust the base level so that optimum is achieved.

The arrangement 600 comprises a power amplifier (PA) 620 (having an RF input 621 and an RF output 622), a base level generator (BL GEN) 640, a ramp shape generator (RAMP GEN) 630 and an adder (ADD) 650.

The base level generator generates a base level adapted based on measurements performed by a measurement unit (MEAS) 670, e.g. a radio tester, on the PA output 622 (for example as described in connection to 230 of Figure 2). The ramp shape generator generates a ramp shape (for example as described in connection to 240 of Figure 2).

The adder 650 combines the generated base level and ramp shape and outputs a power amplifier control signal (PA voltage control) 652 which is used to control the power amplifier 620.

In this embodiment, the system comprise a DC/DC converter 660 that receives the power amplifier control signal 652 as an input signal and outputs a power amplifier supply voltage (PA voltage) 662 to control the power amplifier based on the power amplifier control signal. The DC/DC converter 660 is fed by a supply voltage 661.

It should be noted that a system can be a mixture of the two alternatives in Figure 5 and Figure 6. Thus, the measured switching spectrum signal is fed back to the model as any other in signal and adaptation takes place inside the model.

In Figure 5 and Figure 6 the voltage ramps are generated by a DC/DC converter feeding the PA, which then generates the power ramps as a consequence. It should be noted that other solutions exist as well. One solution might be an integrated PA module that just requires an external ramp signal to be applied. Alternatively or additionally, the whole solution with ramp generation, modeling, measuring and the like might be integrated into one module requiring only a minimum of external signals.

When applying the teachings herein, the unwanted spectral emissions can be kept in optimum (at a level close to the transmission modulation spectrum), also under non-nominal operating conditions. In an actual implementation, the SdT disturbance on neighboring channels (+/- 400 kHz) was reduced by up to 20 dB for the lowest power levels. An advantage of having a feedback signal as depicted in Figures 3 and 6 is that phenomena like unit-to-unit variations and/or aging can be adjusted for as well.

The described embodiments and their equivalents may be realized in software or hardware or a combination thereof. For example, embodiments may be implemented as a software add-on to an existing base level tuning (e.g. base on known or future methods). They may be performed by general-purpose circuits associated with or integral to a communication device, such as digital signal processors (DSP), central processing units (CPU), co-processor units, field-programmable gate arrays (FPGA) or other programmable hardware, or by specialized circuits such as for example application-specific integrated circuits (ASIC). All such forms are contemplated to be within the scope of the invention.

The invention may be embodied within an electronic apparatus (such as a wireless communication device) comprising circuitry/logic or performing methods according to any of the embodiments. The electronic apparatus may, for example, be a portable or handheld mobile radio communication equipment, a mobile radio terminal, a mobile telephone, a communicator, an electronic organizer, a smartphone, a computer, a notebook, or a mobile gaming device.

According to some embodiments, a computer program product comprises a computer readable medium such as, for example, a diskette or a CD-ROM. The computer readable medium may have stored thereon a computer program comprising program instructions. The computer program may be loadable into a data-processing unit, which may, for example, be comprised in a mobile terminal. When loaded into the data-processing unit, the computer program may be stored in a memory associated with or integral to the data-processing unit. According to some embodiments, the computer program may, when loaded into and run by the data-processing unit, cause the data-processing unit to execute method steps according to, for example, the method shown in Figure 2.

The invention has been described herein with reference to various embodiments. However, a person skilled in the art would recognize numerous variations to the described embodiments that would still fall within the scope of the invention. For example, the method embodiments described herein describes example methods through method steps being performed in a certain order. However, it is recognized that these sequences of events may take place in another order without departing from the scope of the invention. Furthermore, some method steps may be performed in parallel even though they have been described as being performed in sequence.

In the same manner, it should be noted that in the description of embodiments, the partition of functional blocks into particular units is by no means limiting to the invention. Contrarily, these partitions are merely examples. Functional blocks described herein as one unit may be split into two or more units. In the same manner, functional blocks that are described herein as being implemented as two or more units may be implemented as a single unit without departing from the scope of the invention.

Hence, it should be understood that the limitations of the described embodiments are merely for illustrative purpose and by no means limiting. Instead, the scope of the invention is defined by the appended claims rather than by the description, and all variations that fall within the range of the claims are intended to be embraced therein.

**Claims**

1. A method of minimizing switching transient spectral emission of a wireless communication transmitter due to a power ramp (140), wherein the power ramp comprises a base level (130) and a ramp shape, the method comprising compensating (230) the base level based on changes in variables of a power amplifier of the transmitter.

2. The method of claim 1, wherein the variables of the power amplifier comprise one or more of:

   a transmitter power level;
   a power amplifier voltage;
   a power amplifier input power level;
   a power level index;
   a power control level;
   a current frequency band;
   a fuse value;
   a tuning value;
   a timing value;
   the ramp shape;
   a temperature; and
   a power amplifier age.

3. The method of any of claims 1 to 2 wherein compensating the base level is performed by modeling an optimal base level.

4. The method of any of claims 1 to 2, wherein compensating the base level is performed by automatic compensation based on a power amplifier output measurement.

5. The method of claims 3 and 4 wherein compensating the base level is performed by providing the power amplifier output measurement as an input to the optimal base level modeling.

6. The method of any of claims 1 to 5 further comprising adjusting (240) the ramp shape based on the changes in variables of the power amplifier.

7. A system of a wireless communication transmitter, adapted to minimize switching transient spectral emission of the transmitter due to a power ramp (140) wherein the power ramp comprises a base level (130) and a ramp shape, the system comprising:

a power amplifier (320, 520, 620); and
a base level generator (340, 540, 640) adapted to compensate the base level based on changes in variables of the power amplifier.

8. The system of claim 7 wherein the base level generator is adapted to compensate the base level by modeling an optimal base level.

9. The system of claim 7 wherein the base level generator is adapted to compensate the base level by automatic compensation based on a power amplifier output measurement.

10. The system of claims 8 and 9, further comprising a measurement unit (370) adapted to provide the power amplifier output measurement as an input to the optimal base level modeling.

11. The system of any of claims 7 to 10 further comprising:

a ramp shape generator (330, 530, 630) adapted to generate the ramp shape; and
a combiner (350, 550, 650) adapted to combine the base level and the ramp shape to provide a power amplifier control signal.

12. The system of claim 11 further comprising a power amplifier controller (360, 560, 660) adapted to control a power amplifier supply voltage based on the power amplifier control signal.

13. The system of any of claims 11 to 12 wherein the ramp shape generator is adapted to adjust the ramp shape based on the changes in variables of the power amplifier.

14. A wireless communication transmitter comprising the system of any of claims 7 to 13.

15. A wireless communication device comprising the system of any of claims 7 to 13.

16. A computer program product comprising a computer readable medium, having thereon a computer program comprising program instructions, the computer program being loadable into a data-processing unit and adapted to cause execution of the method according to any of claims 1 to 6 when the computer program is run by the data-processing unit.

Fig. 1

Fig. 2

Fig. 3

Fig. 4

Fig. 5

Fig. 6

**European Patent Office**
Europäisches Patentamt
European Patent Office
Office européen des brevets

## EUROPEAN SEARCH REPORT

**Application Number**

EP 12 17 4581

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2002/140511 A1 (MYERS MARKUS [CA] ET AL) 3 October 2002 (2002-10-03) | 1,2,7, 11,14-16 | INV. H03G3/30 |
| Y | * paragraphs [0004], [0005], [0006], [0007], [0009], [0012], [0014] - [0016]; figure 1 * | 12 | |
| X | US 2005/018780 A1 (KIM DONG-HAN [KR]) 27 January 2005 (2005-01-27) | 1-3,7,8, 11,14-16 | |
| Y | * paragraphs [0010], [0016], [0032], [0040]; figures 3-7 * | 12 | |
| X | WO 2005/025053 A2 (NOKIA CORP [FI]; NOKIA INC [US]; VAYRYNEN JUKKA [FI]; RAUHALA ANTTI H) 17 March 2005 (2005-03-17) | 1-11, 13-15 | |
| Y | * page 3, line 27 - page 4, line 2; claim 19; figures 1A-4B * <br> * page 6, line 19 - page 7, line 10 * | 12 | |
| X | US 7 480 345 B2 (KURAKAMI NORIYUKI [JP] ET AL) 20 January 2009 (2009-01-20) | 1-3,7,8, 11,14-16 | |
| Y | * column 12, line 17 - column 13, line 40; figures 1,6,7,8 * | 12 | **TECHNICAL FIELDS SEARCHED (IPC)** <br> H03G |
| X | US 2006/262879 A1 (SMITH ALAN A [GB] ET AL STUART LEGAL REPRESENTATIVE JULIE [GB] ET AL) 23 November 2006 (2006-11-23) | 1-3,7,8, 11,14,15 | |
| Y | * the whole document * | 12 | |
| X | US 7 418 055 B2 (WENZEL DIETMAR [DE] ET AL) 26 August 2008 (2008-08-26) | 1-3,7,8, 11,14,15 | |
| Y | * the whole document * | 12 | |
| Y | WO 2010/064091 A1 (FREESCALE SEMICONDUCTOR INC [US]; DUPIS FRANCOIS [FR]; TRICHET JACQUES) 10 June 2010 (2010-06-10) | 12 | |
| A | * the whole document * | 1-11, 13-16 | |

The present search report has been drawn up for all claims

| Place of search | Date of completion of the search | Examiner |
|---|---|---|
| Munich | 26 July 2013 | Fritzsche, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 12 17 4581

This annex lists the patent family members relating to the patent documents cited in the above-mentioned European search report.
The members are as contained in the European Patent Office EDP file on
The European Patent Office is in no way liable for these particulars which are merely given for the purpose of information.

26-07-2013

| Patent document cited in search report | | | Publication date | Patent family member(s) | | | Publication date |
|---|---|---|---|---|---|---|---|
| US 2002140511 | A1 | | 03-10-2002 | US | 2002140511 | A1 | 03-10-2002 |
| | | | | WO | 02080356 | A2 | 10-10-2002 |
| US 2005018780 | A1 | | 27-01-2005 | CN | 1592121 | A | 09-03-2005 |
| | | | | DE | 102004033547 | A1 | 10-02-2005 |
| | | | | KR | 20050007818 | A | 21-01-2005 |
| | | | | US | 2005018780 | A1 | 27-01-2005 |
| WO 2005025053 | A2 | | 17-03-2005 | BR | PI0414117 | A | 31-10-2006 |
| | | | | CN | 1875594 | A | 06-12-2006 |
| | | | | EP | 1665699 | A2 | 07-06-2006 |
| | | | | HK | 1091974 | A1 | 19-10-2012 |
| | | | | JP | 4290732 | B2 | 08-07-2009 |
| | | | | JP | 2007504737 | A | 01-03-2007 |
| | | | | KR | 20060052997 | A | 19-05-2006 |
| | | | | RU | 2308814 | C2 | 20-10-2007 |
| | | | | US | 2005054308 | A1 | 10-03-2005 |
| | | | | US | 2006098617 | A1 | 11-05-2006 |
| | | | | WO | 2005025053 | A2 | 17-03-2005 |
| US 7480345 | B2 | | 20-01-2009 | GB | 2389256 | A | 03-12-2003 |
| | | | | GB | 2416254 | A | 18-01-2006 |
| | | | | JP | 4294978 | B2 | 15-07-2009 |
| | | | | JP | 2004007446 | A | 08-01-2004 |
| | | | | US | 2003223510 | A1 | 04-12-2003 |
| | | | | US | 2007201580 | A1 | 30-08-2007 |
| | | | | US | 2007239152 | A1 | 11-10-2007 |
| US 2006262879 | A1 | | 23-11-2006 | AT | 518398 | T | 15-08-2011 |
| | | | | CN | 101273547 | A | 24-09-2008 |
| | | | | EP | 1884036 | A1 | 06-02-2008 |
| | | | | JP | 2008543180 | A | 27-11-2008 |
| | | | | JP | 2011182414 | A | 15-09-2011 |
| | | | | KR | 20080016876 | A | 22-02-2008 |
| | | | | US | 2006262879 | A1 | 23-11-2006 |
| | | | | WO | 2006127950 | A1 | 30-11-2006 |
| US 7418055 | B2 | | 26-08-2008 | AT | 301882 | T | 15-08-2005 |
| | | | | CN | 1515072 | A | 21-07-2004 |
| | | | | DE | 10124179 | A1 | 25-07-2002 |
| | | | | EP | 1388205 | A2 | 11-02-2004 |
| | | | | US | 2004102207 | A1 | 27-05-2004 |
| | | | | WO | 02093759 | A2 | 21-11-2002 |
| WO 2010064091 | A1 | | 10-06-2010 | US | 2011221523 | A1 | 15-09-2011 |
| | | | | WO | 2010064091 | A1 | 10-06-2010 |

EP 2 660 976 A1

**ANNEX TO THE EUROPEAN SEARCH REPORT
ON EUROPEAN PATENT APPLICATION NO.**

EP 12 17 4581

This annex lists the patent family members relating to the patent documents cited in the above-mentioned European search report.
The members are as contained in the European Patent Office EDP file on
The European Patent Office is in no way liable for these particulars which are merely given for the purpose of information.

26-07-2013

| Patent document cited in search report | Publication date | Patent family member(s) | Publication date |
|---|---|---|---|
| --------------------------------------------------------------------------------- | | | |

EPO FORM P0459

For more details about this annex : see Official Journal of the European Patent Office, No. 12/82

16

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 20070073069 A